(19) **Europäisches Patentamt**
**European Patent Office**
**Office européen des brevets**

(11) **EP 3 404 836 A1**

(12) **EUROPEAN PATENT APPLICATION**

(43) Date of publication:
**21.11.2018 Bulletin 2018/47**

(51) Int Cl.:
**H03M 3/00** (2006.01)

(21) Application number: **17171673.1**

(22) Date of filing: **18.05.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Technische Universität Berlin 10623 Berlin (DE)**

(72) Inventors:
• **GERFERS, Friedel 14195 Berlin (DE)**
• **RUNGE, Marcel 14052 Berlin (DE)**

(74) Representative: **Fischer, Uwe Patentanwalt Moritzstraße 22 13597 Berlin (DE)**

(54) **SIGMA-DELTA MODULATOR COMPRISING DIGITAL-TO-ANALOG CONVERTER ERROR CORRECTION**

(57) An embodiment of the invention relates to a method of operating a system comprising a digital-to-analog-converter (18), wherein an output signal (yout(t), yout(n)) of the system is improved by completely or at least partly compensating a non-linearity error of the digital-to-analog-converter (18), said method comprising the steps of: determining an error value (X1, X2, X3, Xn, $X_{1,LH}$, $X_{1,ST}$, $X_{1,HL}$, $X_{2,LH}$, $X_{2,ST}$, $X_{2,HL}$, $X_{N,LH}$, $X_{N,ST}$, $X_{N,HL}$) that quantifies the deficiency of at least one weight (g1-gN) of the digital-to-analog-converter (18), determining a digital correction value (yc(n)) based on said error value, and completely or at least partly compensating the non-linearity error of the digital-to-analog-converter (18) on the basis of the digital correction value (yc(n)). The embodiment is further characterized in that a digital input signal (y(n)), that itself forms the input signal of the digital-to-analog-converter (18) or at least shows the same signal transitions (LH, ST, HL) over time as the input signal of the digital-to-analog-converter (18), is analyzed regarding a signal transition (LH, ST, HL) or signal transitions (LH, ST, HL) in the past. The step of determining the digital correction value (yc(n)) includes taking into account whether or not a signal transition (LH, ST, HL) or signal transitions (LH, ST, HL) have taken place in the past.

Fig. 5

EP 3 404 836 A1

## Description

The invention relates to a method of operating a system comprising a digital-to-analog-converter. The invention also relates to a system that comprises a digital-to-analog-converter.

## Background of the invention

The publication "Background DAC Error Estimation Using a Pseudo Random Noise Based Correlation Technique for Sigma-Delta Analog-to-Digital Converters" (Pascal Witte and Maurits Ortmanns, IEEE TRANSACTIONS ON CIRCUITS AND SYSTEMS-I: REGULAR PAPERS, VOL. 57, NO. 7, JULY 2010, pages 1500-1512) discloses a method where an output signal of the system is improved by completely or at least partly compensating a non-linearity error in form of a mismatch value. The method comprises the steps of: determining an error value that quantifies the deficiency of at least one weight of the digital-to-analog-converter, determining a digital correction value based on said error value, and completely or at least partly compensating the non-linearity error of the digital-to-analog-converter on the basis of the digital correction value.

## Objective of the present invention

An objective of the present invention is to provide an improved method of operating a system that comprises a digital-to-analog-converter.

A further objective of the present invention is to provide a system that comprises a digital-to-analog-converter and exhibits an improved performance compared to prior art systems.

## Brief summary of the invention

An embodiment of the present invention relates to method of operating a system comprising a digital-to-analog-converter, wherein an output signal of the system is improved by completely or at least partly compensating a non-linearity error of the digital-to-analog-converter, said method comprising the steps of: determining at least one error value that quantifies the deficiency of at least one weight of the digital-to-analog-converter, determining a digital correction value based on said error value, and completely or at least partly compensating the non-linearity error of the digital-to-analog-converter on the basis of the digital correction value. The invention is further characterized in that a digital input signal, that itself forms the input signal of the digital-to-analog-converter or at least shows the same signal transitions over time as the input signal of the digital-to-analog-converter, is analyzed regarding a signal transition or signal transitions in the past. The step of determining the digital correction value includes taking into account whether or not a signal transition or signal transitions have taken place in the past.

An advantage of the present invention is that transition-related errors may be compensated completely or at least partly. Transition-related errors may be caused by precedent transitions of the digital input signal of the digital-to-analog-converter.

A corrected digital signal is preferably generated on the basis of the digital output signal of the analog-to-digital-converter and the digital correction value, e.g. by adding or subtracting.

The output signal of the system is preferably a digital output signal that is formed by the corrected digital signal itself or at least generated based on the corrected digital signal.

According to another exemplary embodiment, the digital input signal of the digital-to-analog-converter is generated on the basis of a digital input signal of the system and the digital correction value. The output signal of the system may be an analog signal that is formed by the output signal of the digital-to-analog-converter itself or at least generated based on the output signal of the digital-to-analog-converter.

Said step of analyzing the digital input signal preferably includes determining the type of the transition if a transition or transitions have been detected.

The step of determining the digital correction value preferably includes taking the type of the transitions into account.

In said step of analyzing the digital input signal, the digital input signal may be analyzed regarding signal transitions during two or more preceding clock periods of the digital-to-analog-converter.

Alternatively, in said step of analyzing the digital input signal, the digital input signal may be analyzed regarding a signal transition during the preceding clock period of the digital-to-analog-converter, only.

In the latter embodiment, the method preferably comprises the steps of determining an error value matrix that quantifies the error of each weight of the digital-to-analog-converter as a function of whether or not a signal transition has taken place during the preceding clock period of the digital-to-analog-converter, picking the corresponding matrix values from said matrix according to the result of said step of analyzing the digital input signal, and determining the digital correction value based on the matrix values that have been picked.

Said step of analyzing the digital input signal preferably includes determining the type of the transition. The step of determining the digital correction value preferably includes taking the type of the transition into account.

The method may further comprise the steps of determining an error value matrix that quantifies the error of each weight of the digital-to-analog-converter in case of a High-Low-transition, a Low-High-transition and no-change-transition during the preceding clock period of the digital-to-analog-converter, picking the corresponding matrix values according to the result of said step of analyzing the digital input signal, and determining the digital correction value based on the matrix values that have been picked.

A further embodiment of the present invention relates to a system comprising a digital-to-analog-converter and a compensation unit configured for improving an output signal of the system by completely or at least partly compensating a non-linearity error of the digital-to-analog-converter, wherein said compensation unit is configured to carry out the steps of: determining an error value that quantifies the deficiency of at least one weight of the digital-to-analog-converter, and determining a digital correction value based on said error value, said digital correction value completely or at least partly compensating the non-linearity error of the digital-to-analog-converter. The system is further characterized in that the compensation unit is configured to analyze a digital input signal, that itself forms the input signal of the digital-to-analog-converter or at least shows the same signal transitions over time as the input signal of the digital-to-analog-converter, regarding a signal transition or signal transitions in the past. Said step of determining the digital correction value includes taking into account whether or not a signal transition or signal transitions have taken place in the past.

The system may also comprises an analog-to-digital-converter.

The system may form a continuous-time sigma-delta modulator.

Brief description of the drawings

In order that the manner in which the above-recited and other advantages of the invention are obtained will be readily understood, a more particular description of the invention briefly described above will be rendered by reference to specific embodiments thereof which are illustrated in the appended drawings. Understanding that these drawings depict only typical embodiments of the invention and are therefore not to be considered to be limiting of its scope, the invention will be described and explained with additional specificity and detail by the use of the accompanying drawings in which

Fig. 1    illustrates a first exemplary embodiment of system according to the present invention,

Fig. 2    illustrates the generation of mismatch-induced errors in the system of Figure 1,

Fig. 3-4   illustrates the generation of transition-related errors in the system of Figure 1,

Fig. 5    illustrates a second exemplary embodiment of system according to the present invention,

Fig. 6    illustrates the signal-to-noise ratio over frequency without compensation of the transition-related errors in the system of Figure 5,

Fig. 7    illustrates the signal-to-noise ratio over frequency in case of a compensation of the transition-related error in the system of Figure 5, and

Fig. 8    a third exemplary embodiment of system according to the present invention.

Detailed description of the preferred embodiments

The preferred embodiments of the present invention will be best understood by reference to the drawings. It will be readily understood that the present invention, as generally described and illustrated in the figures herein, could vary in a wide range. Thus, the following more detailed description of the exemplary embodiments of the present invention, as represented in the figures, is not intended to limit the scope of the invention, as claimed, but is merely representative of presently preferred embodiments of the invention.

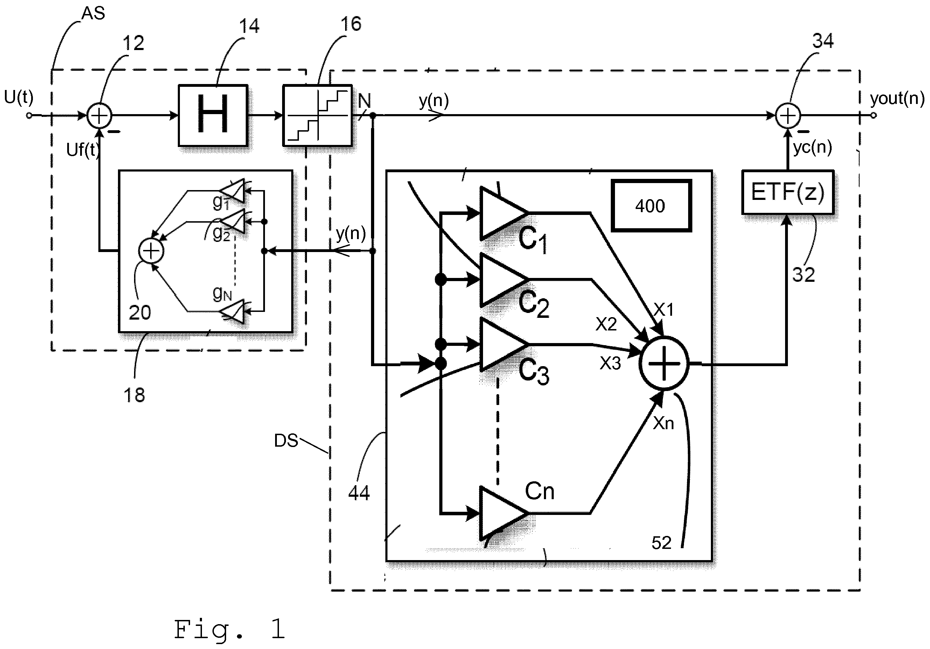

Figure 1 shows a first exemplary embodiment of a system according to the present invention. The system forms a continuous-time sigma-delta (CT$\Sigma\Delta$) modulator. The system comprises a loop filter 14, a multi-bit analog-to-digital converter, hereinafter referred to as quantizer 16, a multi-bit digital-to-analog converter 18, and a subtraction unit 12 where the digital-to-analog-converter's output signal Uf(t) is subtracted from an input signal U(t) of the system.

The digital-to-analog-converter 18 comprises non-linear time-variant weights g1 to gN which are turned on or off depending on the digital input signal y(n) that is applied to the digital-to-analog-converter 18. A summation unit 20 of the digital-to-analog-converter 18 sums up only those weights g1 to gN that are switched on, and thereby forms the analog output signal Uf(t) of the digital-to-analog-converter 18.

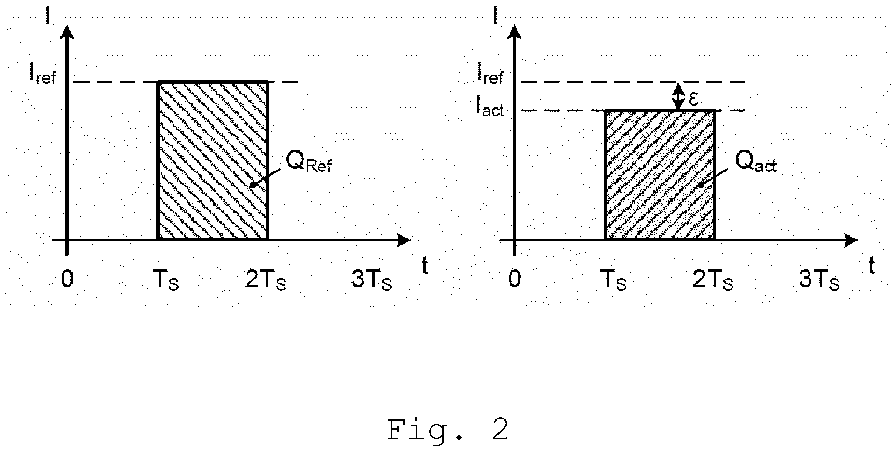

The weights g1 to gN suffer from process mismatch which results in a non-linear transfer function of the digital-to-analog-converter 18. In Figure 2, two unary weights in form of current sources differing by $\varepsilon$ are shown in an exemplary fashion. Given that the output signal Uf(t) of the digital-to-analog-converter 18 is subtracted from the system's input signal U(t) by the subtraction unit 12 and later integrated in the loop filter 14, the charge contribution from each weight g1-gN differs leading to $Q_{Ref} \neq Q_{act}$ (see Figure 2).

In Figure 2, $Q_{Ref}$ designates a reference charge, $Q_{act}$ designates the actual charge of the respective weight, $I_{ref}$ designates the ideal current, $I_{act}$ designates the actual current, and $\varepsilon$ designates the difference between the currents $I_{ref}$ and $I_{act}$.

Since the mismatch-induced error directly appears at the subtraction unit 12, the error cannot be differentiated from the actual input signal U(t).

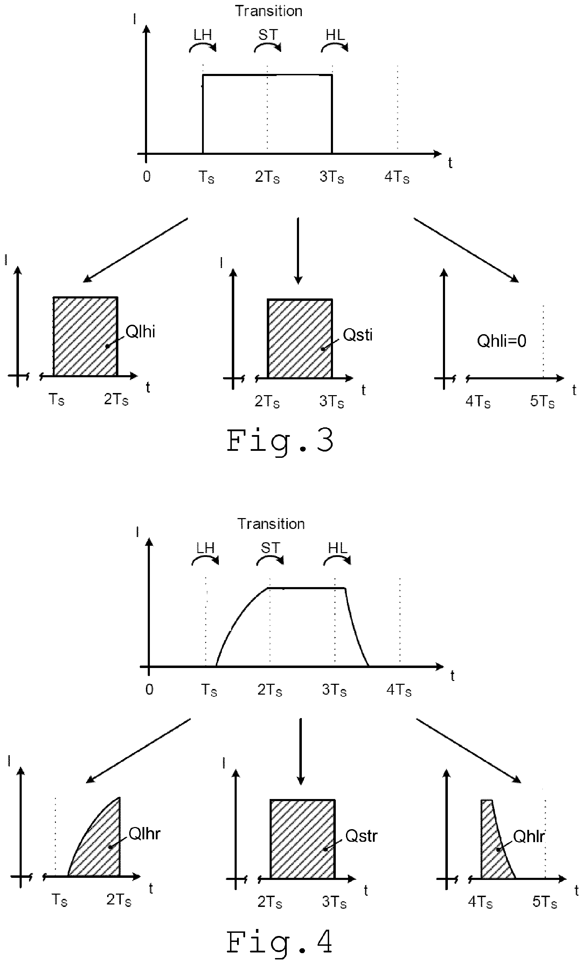

Furthermore, precedent transitions of the digital input signal y(n) may cause transition-related errors in the digital-to-analog-converter 18. The transition-related errors are non-linear and time-variant. The transition-related errors will be explained in further detail with reference to Figures 3 and 4.

Figure 3 shows in an exemplary fashion an output current I from one of the digital-to-analog-converter weights g1-gN in case of an ideal weight without transition-related error. At a time TS, the weight is turned on (transition LH), at a time 2TS it stays constant (transition ST)and at 3TS, the weight is turned off again (transition HL). It can be seen that the weights g1-gN instantly turn on and off.

The instant transition leads to corresponding ideal charges Qlhi, Qsti, and Qhli:

$$Qlhi = Qsti,$$

and

$$Qhli = 0$$

However, in reality the weight transition time is limited by finite slew rate and settling time as shown in Figure 4. Thus, the integrated charge is now dependent on the type of transition LH (Low-High-transition), ST (steady, no change) or HL (High-Low-transition). It can be seen that

$$Qlhr \neq Qstr,$$

and

$$Qhlr \neq 0$$

As a consequence, transition-related errors are also induced into the summation unit 20 of the digital-to-analog-converter 18. The transition-related errors depend on the transition type LH, ST, or HL of the signal transition during the preceding clock period or periods of each weight g1-gN.

In order to compensate or correct the above mentioned errors, namely the mismatch error $\varepsilon$ (see Figure 2) and the transition-related or transition time induced charge error, the system comprises a compensation unit 44. The compensation unit 44 cooperates with a subtraction unit 34 and an ETF(z)-filter 32. The subtraction unit 34 generates an output signal yout(n) of the system.

The error that is caused by the digital-to-analog-converter 18 propagates from the output of the digital-to-analog-converter 18 to the output of the system. This propagation can be described by a signal transfer function. The ETF(z)-filter 32 simulates this signal transfer function in order to compensate the influence of the signal transfer function and provide an appropriate digital correction value yc(n).

The compensation unit 44, the subtraction unit 34 and the ETF(z)-filter 32 form the digital side DS of the system. The digital side DS is connected with the analog side AS of the system via the quantizer 16.

For each weight g1-gN of the digital-to-analog-converter 18 the compensation unit 44 comprises a correction subunit C1-Cn. The subunits C1-Cn are connected by a summation unit 52.

Each correction subunit C1-Cn is individually assigned to a corresponding weight g1-gN of the digital-to-analog-converter 18. Each correction subunit C1-Cn evaluates the binary bit information that is inputted into the corresponding weight g1-gN and outputs a corresponding error value X1-Xn which is either zero (in case of a binary bit information "0") or a non zero (in case of a binary bit information "1").

In the system described in the above mentioned publication "Background DAC Error Estimation Using a Pseudo Random Noise Based Correlation Technique for Sigma-Delta Analog-to-Digital Converters" the error values X1-Xn are constant or at least quasi-constant. In the system of Figure 1, however, the error values X1-Xn vary depending on transition or signal transitions in the past. To this end, the compensation unit 44 includes a transition detection module 400 which analyzes the digital input signal y(n) of the digital-to-analog-converter 18 regarding a signal transition or signal transitions in the past.

For instance, the transition detection module 400 may evaluate the digital input signal y(n) with respect to a time frame that includes a plurality of preceding clock periods of the digital-to-analog-converter 18 in order to establish the history of the operation of the corresponding weights g1-gN in the recent past.

Alternatively, the transition detection module 400 may evaluate the digital input signal y(n) just for a period of time that covers the preceding clock period of the digital-to-analog-converter 18.

Further, the transition detection module 400 may distinguish between types of transitions.

Depending on the results of this analysis, the transition detection module 400 determines the values X1-Xn and provides them to the correction subunits C1-Cn which operate based on these values X1-Xn as described above.

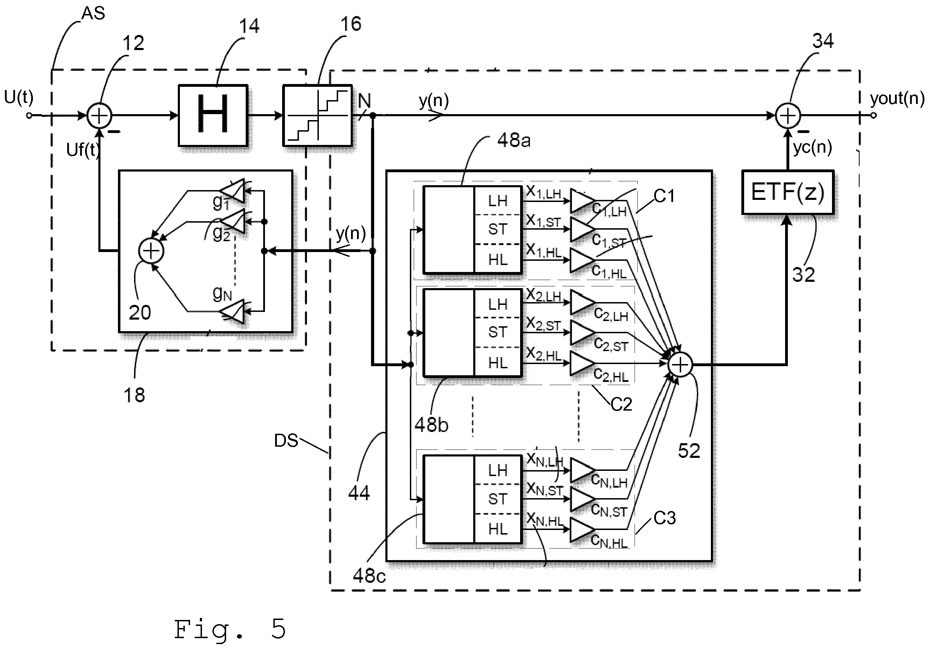

Figure 5 shows a second exemplary embodiment of a system according to the present invention. Each subunit C1-Cn comprises a transition detection module 48a, 48b, 48c and three auxiliary elements $C_{1,LH}$, $C_{1,ST}$, $C_{1,HL}$, $C_{2,LH}$, $C_{2,ST}$, $C_{2,HL}$, $C_{N,LH}$, $C_{N,ST}$ and $C_{N,HL}$. One of the three auxiliary elements of each subunit is activated and the other ones are deactivated depending on the preceding transition LH, ST or HL (see Figure 3 and 4). The output values of the auxiliary elements (in case that the latter are switched on), form transition-dependent error values that are designated by reference signs $X_{1,LH}$, $X_{1,ST}$, $X_{1,HL}$, $X_{2,LH}$, $X_{2,ST}$, $X_{2,HL}$, $X_{N,LH}$, $X_{N,ST}$, and $X_{N,HL}$.

The error values $X_{1,LH}$, $X_{1,ST}$, $X_{1,HL}$, $X_{2,LH}$, $X_{2,ST}$, $X_{2,HL}$, $X_{N,LH}$, $X_{N,ST}$, and $X_{N,HL}$ may form an error value matrix ($\underline{X}$) that quantifies the error of each weight of the digital-to-analog-converter as a function of whether or not a signal transition has taken place during the preceding clock period of the digital-to-analog-converter 18. By picking the corresponding matrix values from the matrix ($\underline{X}$) depending on the corresponding preceding transitions LH, ST or HL, the three auxiliary elements $C_{1,LH}$, $C_{1,ST}$, $C_{1,HL}$, $C_{2,LH}$, $C_{2,ST}$, $C_{2,HL}$, $C_{N,LH}$, $C_{N,ST}$ and $C_{N,HL}$ may be operated as shown in Figure 5.

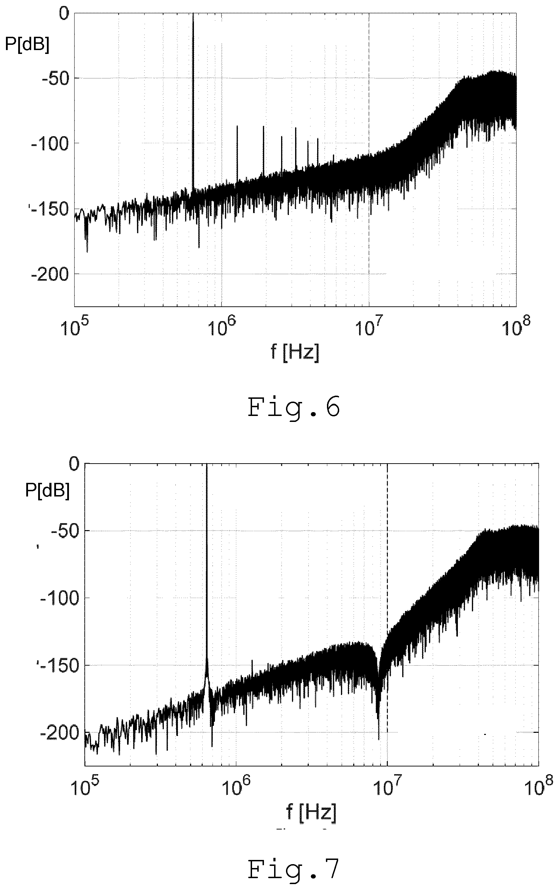

Figures 6 and 7 visualises the positive impact of the transition detection in the embodiment of Figure 5. More specifically, Figures 6 and 7 show the power spectrum density P over the frequency.

In Figure 6, the compensation unit 44 of Figure 5 compensates the mismatch error $\varepsilon$ (see Figure 2), only, and as such works in the same way as the compensation unit known from the above mentioned publication "Background DAC Error Estimation Using a Pseudo Random Noise Based Correlation Technique for Sigma-Delta Analog-to-Digital Converters". A signal- to-noise ratio of 84 dB is achieved.

In contrast, in Figure 7, the transition detection is activated and both the mismatch error $\varepsilon$ (see Figure 2) and the transition-related or transition time induced charge error are compensated. A signal- to-noise ratio of 107 dB is achieved.

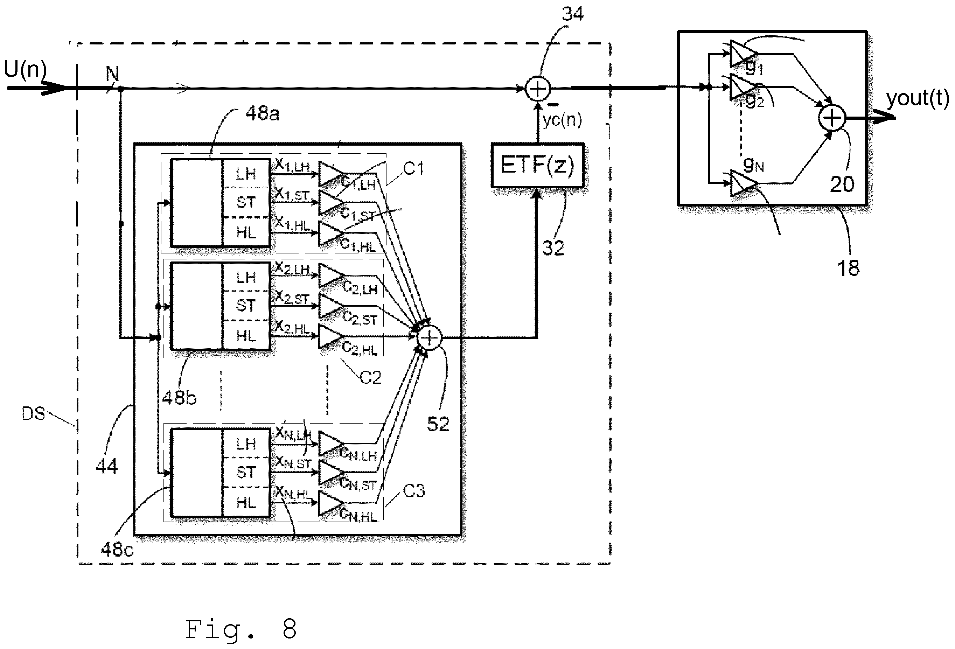

Figure 8 shows a third exemplary embodiment of a system according to the present invention. The system comprises a digital-to-analog-converter 18, a compensatiopn unit 44 and a subtraction unit 34. In contrary to the first and second embodiments discussed above, the digital input signal of the digital-to-analog-converter 18 is generated on the basis of a digital input signal U(n) of the system and the digital correction value yc(n). The output signal yout(t) of the system is an analog signal that is formed by the output signal of the digital-to-analog-converter 18 itself.

Regarding the functionality of the compensation unit 44, the explanations given above with respect to Figures 1-5 apply correspondingly.

**Claims**

1. Method of operating a system comprising a digital-to-analog-converter (18), wherein an output signal (yout(t), yout(n)) of the system is improved by completely or at least partly compensating a non-linearity error of the digital-to-analog-converter (18), said method comprising the steps of:

   - determining at least one error value (X1, X2, X3, Xn, $X_{1,LH}$, $X_{1,ST}$, $X_{1,HL}$, $X_{2,LH}$, $X_{2,ST}$, $X_{2,HL}$, $X_{N,LH}$, $X_{N,ST}$, $X_{N,HL}$) that quantifies the deficiency of at least one weight (g1-gN) of the digital-to-analog-converter (18),
   - determining a digital correction value (yc(n)) based on said error value, and
   - completely or at least partly compensating the non-linearity error of the digital-to-analog-converter (18) on the basis of the digital correction value (yc(n)),

   **characterized in that**

   - a digital input signal (y(n)), that itself forms the input signal of the digital-to-analog-converter (18) or at least shows the same signal transitions (LH, ST, HL) over time as the input signal of the digital-to-analog-converter (18), is analyzed regarding a signal transition (LH, ST, HL) or signal transitions (LH, ST, HL) in the past, and
   - the step of determining the digital correction value (yc(n)) includes taking into account whether or not a signal transition (LH, ST, HL) or signal transitions (LH, ST, HL) have taken place in the past.

2. Method of claim 1 wherein the system also comprises an analog-to-digital-converter (16).

3. Method of claim 2 wherein

   - a corrected digital signal is generated on the basis of the digital output signal of the analog-to-digital-converter (16) and the digital correction value (yc(n)), and
   - the output signal (yout(n)) of the system is a digital output signal that is formed by the corrected digital signal itself or at least generated based on the corrected digital signal.

4. Method of claim 2 wherein

   - the digital input signal of the digital-to-analog-converter (18) is generated on the basis of a digital input signal (U(n)) of the system and the digital correction value (yc(n)), and
   - the output signal (yout(t)) of the system is an analog signal that is formed by the output signal of the digital-to-analog-converter (18) itself or at least generated based on the output signal of the digital-to-analog-converter (18).

5. Method of any of the preceding claims wherein

   - said step of analyzing the digital input signal (y(n)) includes determining the type of the transition (LH, ST, HL) if a transition (LH, ST, HL) or transitions (LH, ST, HL) have been detected, and

- the step of determining the digital correction value (yc(n)) includes taking the type of the transitions (LH, ST, HL) into account.

6. Method of any of the preceding claims wherein in said step of analyzing the digital input signal (y(n)), the digital input signal (y(n)) is analyzed regarding signal transitions (LH, ST, HL) during one or more preceding clock periods of the digital-to-analog-converter (18).

7. Method of any of the preceding claims wherein in said step of analyzing the digital input signal (y(n)), the digital input signal (y(n)) is analyzed regarding a signal transition (LH, ST, HL) during the preceding clock period of the digital-to-analog-converter (18), only.

8. Method of claim 7, further comprising the steps of

    - determining an error value matrix ($\underline{X}$) that quantifies the error of each weight (g1-gN) of the digital-to-analog-converter (18) as a function of whether or not a signal transition (LH, ST, HL) has taken place during the preceding clock period of the digital-to-analog-converter (18),
    - picking the corresponding matrix values from said matrix ($\underline{X}$) according to the result of said step of analyzing the digital input signal (y(n)), and
    - determining the digital correction value (yc(n)) based on the matrix values that have been picked.

9. Method of claim 7 wherein

    - said step of analyzing the digital input signal (y(n)) includes determining the type of the transition (LH, ST, HL), and
    - the step of determining the digital correction value (yc(n)) includes taking the type of the transition (LH, ST, HL) into account.

10. Method of claim 9 further comprising the steps of

    - determining an error value matrix that quantifies the error of each weight (g1-gN) of the digital-to-analog-converter (18) in case of a High-Low-transition (HL), a Low-High-transition (LH) and no-change-transition (ST) during the preceding clock period of the digital-to-analog-converter (18),
    - picking the corresponding matrix values according to the result of said step of analyzing the digital input signal (y(n)), and
    - determining the digital correction value (yc(n)) based on the matrix values that have been picked.

11. System comprising a digital-to-analog-converter (18) and a compensation unit (44) configured for improving an output signal (yout(t), yout(n)) of the system by completely or at least partly compensating a non-linearity error of the digital-to-analog-converter (18), wherein said compensation unit (44) is configured to carry out the steps of:

    - determining an error value that quantifies the deficiency of at least one weight (g1-gN) of the digital-to-analog-converter (18), and
    - determining a digital correction value (yc(n)) based on said error value, said digital correction value (yc(n)) completely or at least partly compensating the non-linearity error of the digital-to-analog-converter (18),

**characterized in that**

    - the compensation unit (44) is configured to analyze a digital input signal (y(n)), that itself forms the input signal of the digital-to-analog-converter (18) or at least shows the same signal transitions (LH, ST, HL) over time as the input signal of the digital-to-analog-converter (18), regarding a signal transition (LH, ST, HL) or signal transitions (LH, ST, HL) in the past, and
    - said step of determining the digital correction value (yc(n)) includes taking into account whether or not a signal transition (LH, ST, HL) or signal transitions (LH, ST, HL) have taken place in the past.

12. System of claim 11 wherein the system also comprises an analog-to-digital-converter (16).

13. System of claim 12 wherein the system forms a continuous-time sigma-delta modulator.

Fig. 1

EP 3 404 836 A1

EP 3 404 836 A1

Fig. 2

Fig.3

Fig.4

Fig. 5

Fig.6

Fig.7

Fig. 8

EP 3 404 836 A1

Europäisches
Patentamt

European
Patent Office

Office européen
des brevets

# EUROPEAN SEARCH REPORT

**Application Number**

EP 17 17 1673

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HO STACY ET AL: "A 23 mW, 73 dB Dynamic Range, 80 MHz BW Continuous-Time Delta-Sigma Modulator in 20 nm CMOS", IEEE JOURNAL OF SOLID-STATE CIRCUITS, IEEE SERVICE CENTER, PISCATAWAY, NJ, USA, vol. 50, no. 4, 1 April 2015 (2015-04-01), pages 908-919, XP011576716, ISSN: 0018-9200, DOI: 10.1109/JSSC.2014.2387849 [retrieved on 2015-03-24] * figures 1, 8 * * page 911, right-hand column, line 1 - page 912, left-hand column, line 1 * * page 917, left-hand column, line 5 - page 917, right-hand column, line 5 * ----- | 1-13 | INV. H03M3/00 |
| X | US 2004/208249 A1 (RISBO LARS [DK] ET AL) 21 October 2004 (2004-10-21) * figures 14,15 * * paragraphs [0074] - [0085] * ----- | 1-13 | |
| X | EP 1 418 674 A1 (MOTOROLA INC [US]) 12 May 2004 (2004-05-12) * figures 5, 8 * * paragraphs [0001] - [0047] * ----- -/-- | 1-13 | TECHNICAL FIELDS SEARCHED (IPC) H03M |

The present search report has been drawn up for all claims

| Place of search | Date of completion of the search | Examiner |
|---|---|---|
| The Hague | 30 October 2017 | Jespers, Michaël |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

Europäisches
Patentamt

European
Patent Office

Office européen
des brevets

**EUROPEAN SEARCH REPORT**

Application Number

EP 17 17 1673

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KAUFFMAN JOHN G ET AL: "A 72 dB DR, CT [Delta][Sigma] Modulator Using Digitally Estimated, Auxiliary DAC Linearization Achieving 88 fJ/conv-step in a 2", IEEE JOURNAL OF SOLID-STATE CIRCUITS, IEEE SERVICE CENTER, PISCATAWAY, NJ, USA, vol. 49, no. 2, 1 February 2014 (2014-02-01), pages 392-404, XP011538051, ISSN: 0018-9200, DOI: 10.1109/JSSC.2013.2289887 [retrieved on 2014-01-24] * figures 1, 3, 8 * * page 397, left-hand column, line 4 - page 399, left-hand column, line 19 * * page 400, right-hand column, line 15 - page 401, left-hand column, line 25 * ----- | 1-13 | |

TECHNICAL FIELDS
SEARCHED      (IPC)

The present search report has been drawn up for all claims

| Place of search | Date of completion of the search | Examiner |
|---|---|---|
| The Hague | 30 October 2017 | Jespers, Michaël |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

EP 17 17 1673

This annex lists the patent family members relating to the patent documents cited in the above-mentioned European search report.
The members are as contained in the European Patent Office EDP file on
The European Patent Office is in no way liable for these particulars which are merely given for the purpose of information.

30-10-2017

| Patent document cited in search report | | Publication date | Patent family member(s) | | Publication date |
|---|---|---|---|---|---|
| US 2004208249 | A1 | 21-10-2004 | NONE | | |
| EP 1418674 | A1 | 12-05-2004 | AT | 456193 T | 15-02-2010 |
| | | | AU | 2003301779 A1 | 07-06-2004 |
| | | | EP | 1418674 A1 | 12-05-2004 |
| | | | US | 2006012499 A1 | 19-01-2006 |
| | | | WO | 2004042932 A2 | 21-05-2004 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

• **PASCAL WITTE A ; MAURITS ORTMANNS.** Background DAC Error Estimation Using a Pseudo Random Noise Based Correlation Technique for Sigma-Delta Analog-to-Digital Converters. *IEEE TRANSACTIONS ON CIRCUITS AND SYSTEMS-I: REGULAR PAPERS,* July 2010, vol. 57 (7), 1500-1512